# EUROPEAN PATENT APPLICATION

(11) **EP 4 006 239 A1**
(43) Date of publication of application: **01.06.2022**
(21) Application number: 20929334.9
(22) Date of filing: 30.03.2020
(51) Int. Cl.: E02F 9/20

(54) **CONSTRUCTION MACHINE**

(71) Applicant: Hitachi Construction Machinery Co., Ltd., Tokyo 110-0015 (JP)
(72) Inventor: WATANABE, Akira, Tsuchiura-shi, Ibaraki 300-0013 (JP); YANO, Manabu, Tsuchiura-shi, Ibaraki 300-0013 (JP); OOTA, Yasunori, Tsuchiura-shi, Ibaraki 300-0013 (JP); IMAI, Yusuke, Tsuchiura-shi, Ibaraki 300-0013 (JP)
(74) Representative: Manitz Finsterwald Patent- und Rechtsanwaltspartnerschaft mbB
(86) International application number: PCT/JP2020/014542
(87) International publication number: WO 2021/199154

(57) **Abstract**

Provided is a hydraulic excavator 1 including a starter motor 11 for starting an engine 2 with electric power supplied from a lead-acid battery 12, a second electric system 15 connected in parallel with a first electric system 14 to connect a lead-acid battery 12 and a 24V electrical equipment 16, a 48V battery 18 for supplying electric power to the second electric system 15, a relay 17 for disconnecting connection between the first electric system 14 and the second electric system 15, and a vehicle body controller 13 connected to the second electric system 15 to control the starter motor 11 and the relay 17 or the like. The vehicle body controller 13 estimates a remaining charge amount of the lead-acid battery 12 and disables driving of the starter motor 11 until an estimation result is higher than or equal to a threshold, and when the estimation result is higher than or equal to the threshold, disconnects the connection between the first electric system 14 and the second electric system 15 by using the relay 17.

## Description

### Technical Field

The present invention relates to construction machines.

### Background Art

In recent years, electrification in the construction machines, such as hydraulic excavators, has advanced with concern for the environment and to achieve improved fuel economy. Along with this, an increasing number of construction machines mount a new battery with high voltage and high performance, in contrast to a lead-acid battery, in order to supply electric power to their electrified portions.

Meanwhile, electrical equipment, such as sensors, attached to the hydraulic excavators and a starter motor for starting an engine and the like are supplied with electric power from a conventional lead-acid battery because it is difficult to entirely change the power supply circuits to those compatible with a new battery. In the case of the starter motor for starting an engine, for example, a high starting torque is required due to a large size of the engine and a high drag torque of a main pump, and thus the one with a low-speed and high torque is employed to start the engine with the electric power supplied from the conventional lead-acid battery.

Patent Literature 1 discloses a hybrid excavator including a starter motor for starting an engine, an electrified turning motor, an assisting electric generator motor that performs assistance of the engine and electricity generation, and an electrical storage device for storing the generated electricity. The starter motor is supplied with electric power from a lead-acid battery.

### Citation List

### Patent Literature

Patent Literature 1: JP 2018-87496 A

### Summary of Invention

### Technical Problem

However, the above-described hydraulic excavators have the following problems. That is, when the lead-acid battery is at low charge or the battery has a low charge capacity due to deterioration, the electric power having used for driving the starter motor causes a voltage drop in the lead-acid battery or a large voltage ripple. This may result in operational failure of the electrical equipment that is supplied with electric power from the lead-acid battery, thus leading to breakdown and malfunction of the electrical equipment. In addition, the electrified hydraulic excavators may be greatly affected by the malfunction of the electrical equipment as compared to the conventional hydraulic excavators.

The present invention provides a construction machine that can suppress an influence on the electrical equipment and can prevent breakdown and malfunction of the electrical equipment, even if the power consumption of the starter motor during starting an engine causes a voltage drop in an electrical storage device or a large voltage fluctuation.

### Solution to Problem

A construction machine according to the present invention includes: an engine; a starter motor configured to start the engine with electric power supplied from a first electrical storage device; a first electric system configured to connect the first electrical storage device and the starter motor; a second electric system configured to connect the first electrical storage device and electrical equipment, the second electric system being connected in parallel with the first electric system; a second electrical storage device configured to supply electric power to the second electric system; a disconnecting device capable of disconnecting power supply from the first electrical storage device to the second electric system by disconnecting connection between the first electric system and the second electric system; and a vehicle body controller configured to control at least the starter motor and the disconnecting device, the vehicle body controller being connected to the second electric system. The vehicle body controller disables driving of the starter motor until an estimation result of a remaining amount of the first electrical storage device is higher than or equal to a threshold set in advance, and when the estimation result is higher than or equal to the threshold, disconnects the connection between the first electric system and the second electric system by using the disconnecting device.

In the construction machine according to the present invention, when an estimation result of the remaining amount of the first electrical storage device is higher than or equal to a threshold, the vehicle body controller disconnects the connection between the first electric system and the second electric system by using the disconnecting device, whereby the first electrical storage device is disconnected from the electrical equipment. That is, by using the disconnecting device, the electrical equipment having a likelihood of breakdown and malfunction due to a voltage drop or a voltage ripple is separated from the first electrical storage device supplying electric power to the starter motor, and stably operates with electric power supplied from the second electric system. Therefore, the construction machine according to the present invention can suppress an influence on the electrical equipment and can prevent malfunction and breakdown of the electrical equipment, even if the power consumption of the starter motor during starting an engine causes a voltage drop in the first electrical storage device or a large voltage fluctuation.

### Advantageous Effects of Invention

According to the present invention, it is possible to suppress an influence on the electrical equipment and to prevent breakdown and malfunction of the electrical equipment, even if the power consumption of the starter motor during starting an engine causes a voltage drop in an electrical storage device or a large voltage fluctuation.

### Brief Description of Drawings

Fig. 1 is a side view of a hydraulic excavator according to an embodiment.
Fig. 2 is a configuration diagram of a system of the hydraulic excavator according to the embodiment.
Fig. 3 is a flowchart showing a control process of engine start preparation.

### Description of Embodiments

Hereinafter, an embodiment of the construction machine according to the present invention will be described with reference to the drawings. Like reference numerals designate like parts throughout the figures of the description, and repeated description thereof will be omitted. In addition, although the following describes the hydraulic excavator as an example of the construction machine, the present invention is not limited to the hydraulic excavator, and can be applied to the construction machine other than the hydraulic excavator.

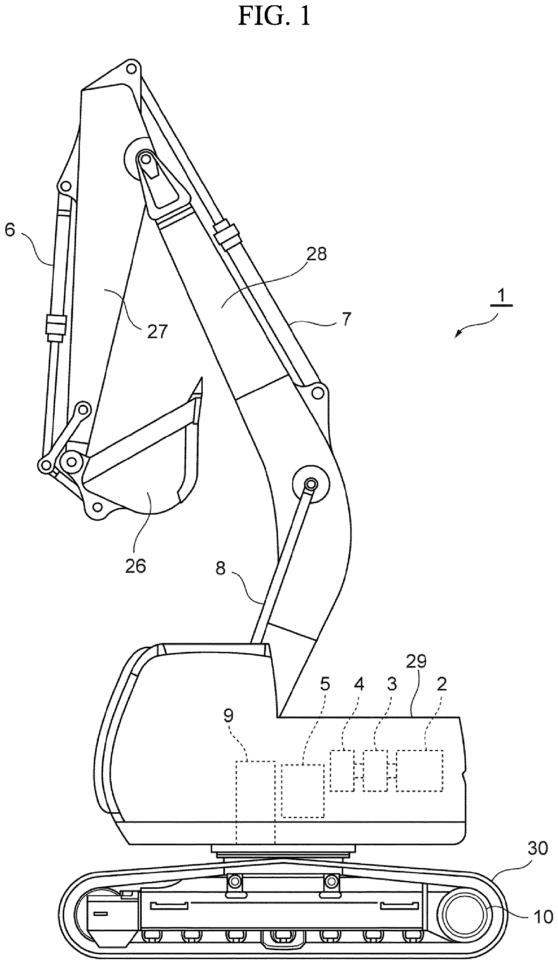

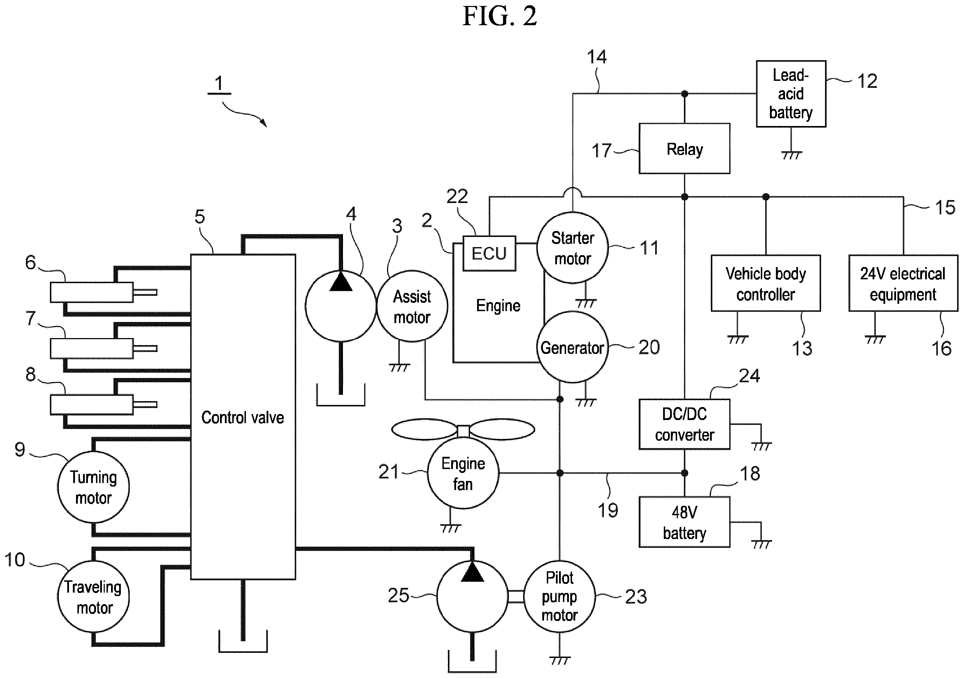

Fig. 1 is a side view of a hydraulic excavator according to an embodiment, and Fig. 2 is a configuration diagram of a system of the hydraulic excavator according to the embodiment. A hydraulic excavator 1 according to the present embodiment is a hybrid hydraulic excavator that drives a main pump 4 with an engine 2 and an assist motor 3. In the hydraulic excavator 1, the pressure oil supplied from the main pump 4 is distributed by a control valve 5 and supplied to a plurality of hydraulic actuators (bucket cylinder 6, arm cylinder 7, boom cylinder 8, turning hydraulic motor 9, traveling hydraulic motor 10) so as to perform digging operation, turning operation, and traveling operation.

The control valve 5 is a flow rate control valve that controls the flow rate of the pressure oil supplied from the main pump 4 to each hydraulic actuator. The bucket cylinder 6 is a hydraulic actuator for driving a bucket 26 and is driven by the pressure oil supplied from the main pump 4. The arm cylinder 7 is a hydraulic actuator for driving an arm 27 and is driven by the pressure oil supplied from the main pump 4. The boom cylinder 8 is a hydraulic actuator for driving a boom 28 and is driven by the pressure oil supplied from the main pump 4.

The turning hydraulic motor 9 is a hydraulic actuator for turning a turning body 29 with respect to a traveling body 30 and is driven by the pressure oil supplied from the main pump 4. The traveling hydraulic motor 10 is a hydraulic actuator for moving forward or backward the traveling body 30 and is driven by the pressure oil supplied from the main pump 4.

These flow rate control valve, hydraulic actuators, and main pump are controlled by a vehicle body controller 13, which will be described later.

The engine 2 is provided with a starter motor 11 for starting the engine 2. The starter motor 11 is driven by electric power supplied from a lead-acid battery (first electrical storage device) 12. The lead-acid battery 12 and the starter motor 11 are electrically connected via a first electric system 14.

Further, the hydraulic excavator 1 includes the vehicle body controller 13 that monitors the state of the vehicle body and controls the vehicle body and also controls the operation or the like of each piece of electrical equipment, and an ECU (engine controller unit) 22 that monitors the state of engine 2 and controls the engine 2. As shown in Fig. 2, the vehicle body controller 13, the ECU 22, and the 24V electrical equipment 16 are electrically connected to the lead-acid battery 12 via a second electric system 15. The 24V electrical equipment 16 includes various sensors, a headlight, and the like attached to the hydraulic excavator 1, for example.

The second electric system 15 is connected in parallel with the first electric system 14 so as to electrically connect the lead-acid battery 12 to the vehicle body controller 13, the 24V electrical equipment 16, and the ECU 22. Between the first electric system 14 and the second electric system 15, a relay (disconnecting device) 17 is provided in the circuit on the positive electrode side. That is, the relay 17 is configured to be able to disconnect the positive electrode side of the first electric system 14 and the second electric system 15. It should be noted that the relay 17 may not necessarily be configured to be able to disconnect the positive electrode side of the first electric system 14 and the second electric system 15, and may be configured to be able to disconnect the negative electrode side or both of the positive electrode side and the negative electrode side of the first electric system 14 and the second electric system 15.

In addition, the relay 17 is configured to be able to disconnect the power supply from the lead-acid battery 12 to the second electric system 15 by disconnecting connection between the first electric system 14 and the second electric system 15. Closing the relay 17 electrically connects the first electric system 14 and the second electric system 15, and supplies electric power from the lead-acid battery 12 to the vehicle body controller 13, the 24V electrical equipment 16, and the ECU 22. Meanwhile, opening the relay 17 disconnects the connection between the first electric system 14 and the second electric system 15, and disconnects the power supply from the lead-acid battery 12 to the vehicle body controller 13, the 24V electrical equipment 16, and the ECU 22.

In the present embodiment, a normally closed relay is used for the relay 17, in which the connection (that is, the closed state) is maintained when a coil is in a non-excited state, for example.

The assist motor 3 is driven by electric power supplied from a 48V battery (second electrical storage device) 18. The assist motor 3 and the 48V battery 18 are electrically connected via a third electric system 19. A generator 20 that generates electric power with motive power of the engine 2, an engine fan 21 that cools a radiator of the engine 2 and is driven by an electric motor (not shown), and a pilot pump motor 23 that drives a pilot pump 25 are each electrically connected to the 48V battery 18 via the third electric system 19. It should be noted that the pilot pump 25 is a pump that supplies pressure oil for operating the control valve 5. An electric motor that drives the engine fan 21 is connected to the third electric system 19.

The 48V battery 18 is configured to supply electric power to the assist motor 3, the engine fan 21, and the pilot pump motor 23, and can be charged with the generator 20. In addition, the 48V battery 18 supplies electric power to the second electric system 15 via a DC/DC converter 24, which will be described later, and further can charge the lead-acid battery 12 via the second electric system 15.

With motive power of the engine 2, the generator 20 supplies electric power to the first electric system 14 and the second electric system 15 via the third electric system 19 and the DC/DC converter 24 (described later).

In the present embodiment, the lead-acid battery 12 has a rated voltage of 24V. Thus, the first electric system 14 and the second electric system 15 are electric systems with a rated voltage of 24V. Meanwhile, the 48V battery 18 has a rated voltage of 48V. Thus, the third electric system 19 is an electric system with a rated voltage of 48V.

In addition, the DC/DC converter (voltage converter) 24 is interposed between the second electric system 15 and the third electric system 19 to convert the voltage from the third electric system 19 to the second electric system 15 and supply electric power to the second electric system 15. This allows the electric power generated by the generator 20 to be supplied to the second electric system 15 and the first electric system 14 after the voltage conversion by the DC/DC converter 24, and further allows the lead-acid battery 12 to be charged.

The vehicle body controller 13 is made up of a microcomputer incorporating, for example, a CPU (Central Processing Unit) that executes operations, a ROM (Read Only Memory) as a secondary storage unit that stores programs for the operations, and a RAM (Random Access Memory) as a temporary storage unit that stores processes of the operations and temporary control variables. By executing the stored programs, the vehicle body controller 13 monitors the state of the vehicle body and controls the vehicle body, and also controls the operation or the like of each piece of electrical equipment.

For example, in addition to driving (for example, starting, stopping) the starter motor 11, the vehicle body controller 13 controls the opening and closing of the relay 17 and the operation of the DC/DC converter 24 or the like, and performs various estimation processes and determination processes. In the present embodiment, the vehicle body controller 13 estimates a remaining charge amount of the lead-acid battery 12, disables driving of the starter motor 11 until an estimation result is higher than or equal to a threshold set in advance, and when the estimation result is higher than or equal to the threshold, disconnects the connection between the first electric system 14 and the second electric system 15 by using the relay 17.

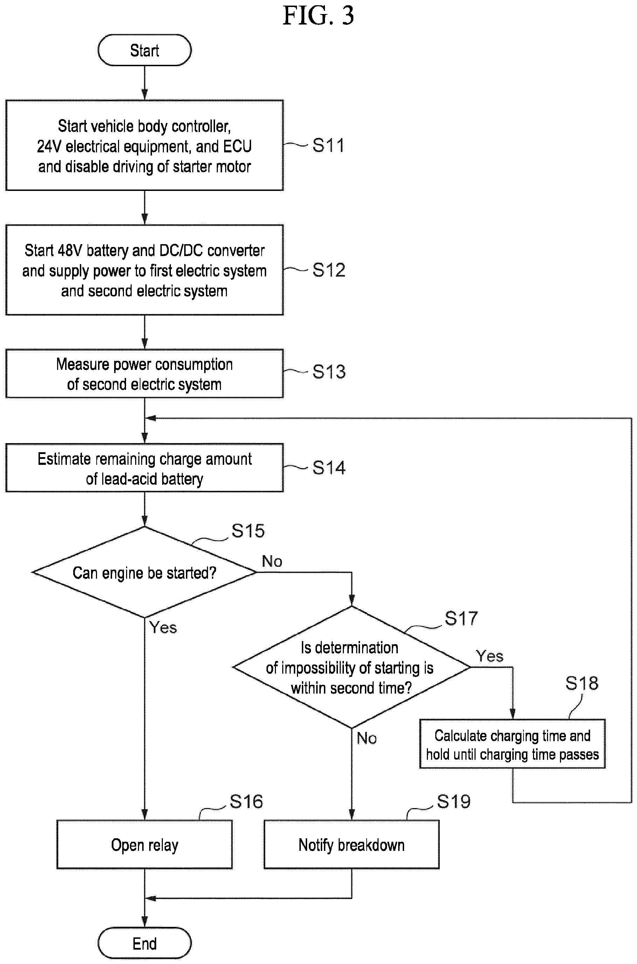

Hereinafter, engine start preparation as a part of the startup of the hydraulic excavator 1 will be described with reference to Fig. 3. The startup is an operation that begins by receiving a key-on signal of a key cylinder, starts the engine 2, and then completes all of the starting of the electrical equipment, that is, an operation before the hydraulic excavator 1 enters normal operation. Herein, the following describes the step of receiving a key-on signal through the step immediately before starting the engine 2, that is, the engine start preparation. The step immediately before starting the engine 2 will be referred to as "engine start preparation completion." This "engine start preparation completion" has the same meaning as the estimation result of the remaining charge amount of the lead-acid battery 12 that is higher than or equal to a threshold set in advance, which will be described later.

As described above, the control process shown in Fig. 3 is started by receiving a key-on signal of a key cylinder. In step S11, the first electric system 14 and the second electric system 15 are electrically connected since a normally closed relay is used for the relay 17. Thus, electric power from the lead-acid battery 12 is supplied to the vehicle body controller 13, the 24V electrical equipment 16, and the ECU 22 via the relay 17 and the second electric system 15. Then, with the electric power supplied from the lead-acid battery 12, the vehicle body controller 13 is started and also each piece of electrical equipment of the 24V electrical equipment 16 and the ECU 22 are started. Even after the vehicle body controller 13, the 24V electrical equipment 16, and the ECU 22 are started, the vehicle body controller 13 maintains the relay 17 in a closed state.

Herein, from completion of starting each piece of electrical equipment of the 24V electrical equipment 16 and the ECU 22 to the engine start preparation completion, the vehicle body controller 13 disables driving of the starter motor 11. Therefore, until the engine start preparation completion, the starter motor 11 will not be driven even by receiving an engine start signal of a key cylinder, and thus the engine 2 will not be started.

In step S12 following step S11, once the 24V electrical equipment 16 is started, the vehicle body controller 13 starts the 48V battery 18 and the DC/DC converter 24. Then, the vehicle body controller 13 causes the DC/DC converter 24 to convert the electric power of the 48V battery 18 to 24V and starts power supply to the first electric system 14 and the second electric system 15.

At this time, the DC/DC converter 24 detects an electric current supplied from the 48V battery 18 to the second electric system 15 by using a current detection unit (not shown) provided in the DC/DC converter 24, and outputs the detection result to the vehicle body controller 13. Further, an output voltage (i.e., voltage of the second electric system 15) of the DC/DC converter 24 is detected by a voltage detection unit (not shown) provided in the second electric system 15, for example, and the detection result is output to the vehicle body controller 13.

In step S13 following step S12, power consumption of the second electric system 15 is measured. For the power consumption of the second electric system 15, a prescribed value entered to the vehicle body controller 13 based on a designed value may be used, but in this example, a value obtained by measurement is used.

When the power consumption of the second electric system 15 is measured, the electric power supplied from the DC/DC converter 24 to the second electric system 15 is measured in a state where the relay 17 is opened. That is, opening the relay 17 disconnects the connection between the first electric system 14 and the second electric system 15, and the electric power from the DC/DC converter 24 is supplied only to the second electric system 15. Thus, the electric power to be measured is equal to the power consumption of the second electric system 15.

In step S14 following step S13, the power supply to the lead-acid battery 12 is restarted in a state where the relay 17 is closed. That is, closing the relay 17 makes connection between the first electric system 14 and the second electric system 15, and thus the electric power from the DC/DC converter 24 is supplied to both of the second electric system 15 and the first electric system 14. Accordingly, a value obtained by the subtraction of the power consumption of the second electric system 15 from the electric power supplied from the DC/DC converter 24 (that is, supply power) is equal to the charging power to the lead-acid battery 12. This allows calculation of a charging current.

When the charging current is small, a value close to an open circuit voltage of the lead-acid battery 12 can be measured. This allows estimation of the remaining charge amount of the lead-acid battery 12. Therefore, when the remaining charge amount of the lead-acid battery 12 is estimated, the vehicle body controller 13 measures the voltage while controlling supply current of the DC/DC converter 24 such that the charging current is zero, so as to estimate the remaining charge amount of the lead-acid battery 12.

In step S15 following step S14, the vehicle body controller 13 compares the remaining charge amount of the lead-acid battery 12 estimated in step S14 (that is, estimation result) with a threshold, and determines whether the engine 2 can be started. The threshold is a prescribed value set in advance based on a remaining charge amount sufficient to start the engine 2.

Herein, if an estimation result is higher than or equal to the threshold, the vehicle body controller 13 determines that the engine 2 can be started. If an estimation result is lower than the threshold, the vehicle body controller 13 determines that starting the engine 2 is impossible.

Then, if the vehicle body controller 13 determines that the engine 2 can be started, the control process proceeds to step S16. In step S16, the vehicle body controller 13 starts also the remaining pieces of electrical equipment and opens the relay 17 after completing the starting so as to disconnect the connection between the first electric system 14 and the second electric system 15. As a result, the engine start preparation is completed. After the end of step S16, a sequential control process ends.

It should be noted that after the engine start preparation is completed, the vehicle body controller 13 inputs an engine start via a key cylinder. At this time, the starter motor 11 rotates with electric power supplied from the lead-acid battery 12 to start the engine 2.

Then, the vehicle body controller 13 monitors the number of revolutions of the engine 2 via the ECU 22, and when the number of revolutions is higher than or equal to a prescribed value, determines that starting the engine 2 is completed. After that, the vehicle body controller 13 closes the relay 17 again.

Meanwhile, if the vehicle body controller 13 determines that the engine 2 cannot be started (that is, starting is impossible) in step S15, the control process proceeds to step S17. In step S17, the vehicle body controller 13 determines whether the determination of impossibility of starting is within a second time. If the vehicle body controller 13 determines that the determination of impossibility of starting is within a second time, the control process proceeds to step S18. In step S18, the vehicle body controller 13 increases the supply power of the DC/DC converter 24 that was once reduced for the estimation of the remaining charge amount of the lead-acid battery 12 in step S14, and charges the lead-acid battery 12.

At this time, the vehicle body controller 13 calculates a charging time based on a difference between the remaining charge amount of the lead-acid battery 12 estimated in step S14 and the threshold used in the determination of whether the engine 2 can be started, and an amount of charging current set in advance. Then, the vehicle body controller 13 places the hydraulic excavator 1 in a standby state until the calculated charging time passes (that is, during charging for starting the engine 2). After the charging time passes, the control process goes back to step S14, where the vehicle body controller 13 estimates the remaining charge amount of the lead-acid battery 12 again to determine again whether the engine 2 can be started (see step S15).

During calculation of a charging time and during charging for starting the engine 2 in step S18, the vehicle body controller 13 notifies an operator of the hydraulic excavator 1 or the like that the lead-acid battery 12 is being charged for starting the engine 2. For example, the vehicle body controller 13 notifies the operator that the lead-acid battery 12 is being charged by displaying such a message on a monitor provided in a cab. In addition, the vehicle body controller 13 notifies the operator or the like of a result of the calculated charging time. This can make the operator less stressed, for example.

Meanwhile, if the vehicle body controller 13 determines that the determination of impossibility of starting is not within a second time in step S17, that is, if the vehicle body controller 13 cannot determine that the engine 2 can be started even through three times of determination, the control process proceeds to step S19. In step S19, the vehicle body controller 13 determines that the lead-acid battery 12 has broken down, and notifies the operator or the like of the breakdown. For example, the vehicle body controller 13 notifies the operator that the lead-acid battery 12 has broken down by displaying such a message on the monitor provided in the cab. After that, the control process ends.

In the hydraulic excavator 1 having the above-described configuration, when an estimation result of the remaining charge amount of the lead-acid battery 12 is higher than or equal to a threshold, the vehicle body controller 13 disconnects the connection between the first electric system 14 and the second electric system 15 by using the relay 17, whereby the lead-acid battery 12 is disconnected from the vehicle body controller 13, the 24V electrical equipment 16, and the ECU 22, or the like. That is, by using the relay 17, the electrical equipment having a likelihood of breakdown and malfunction due to a voltage drop or a voltage ripple, such as the vehicle body controller 13, the 24V electrical equipment 16, and the ECU 22, is separated from the lead-acid battery 12 supplying electric power to the starter motor 11, and stably operates with electric power supplied from the 48V battery 18 via the second electric system 15 and the DC/DC converter 24.

Therefore, it is possible to suppress an influence on the electrical equipment such as the vehicle body controller 13, the 24V electrical equipment 16, and the ECU 22 even if the power consumption of the starter motor 11 during starting an engine causes a voltage drop in the lead-acid battery 12 or a large voltage fluctuation, and thus prevent malfunction and breakdown of the electrical equipment. Furthermore, such a configuration can also be expected to offer greater options of the pieces of electrical equipment to be used for the 24V electrical equipment 16, for example.

It should be noted that in the above description of the present embodiment, when the remaining charge amount of the lead-acid battery 12 is estimated, the vehicle body controller 13 measures the voltage by controlling supply current of the DC/DC converter 24 such that the charging current is zero. However, the present embodiment is not limited thereto. For example, the vehicle body controller 13 may store the ON resistance of the lead-acid battery 12 in advance as a prescribed value and accumulate the ON resistance of the lead-acid battery 12 into the charging current so as to estimate a voltage increase amount during charging, whereby an open circuit voltage of the lead-acid battery 12, that is, the remaining charge amount of the lead-acid battery 12, can be estimated.

The estimation of the remaining charge amount of the lead-acid battery 12 may not necessarily be performed by the vehicle body controller 13. For example, when the lead-acid battery 12 includes a battery managing unit, the remaining charge amount may be estimated using the battery managing unit. In this case, the lead-acid battery 12 outputs an estimation result obtained in the battery managing unit to the vehicle body controller 13.

Although the embodiment of the present invention has been described in detail above, the present invention is not limited to the above embodiment, and various design changes are possible in so far as they are within the spirit of the present invention in the scope of the claims.

### Reference Signs List

- 1: Hydraulic excavator
- 2: Engine
- 3: Assist motor
- 4: Main pump
- 5: Control valve (flow rare control valve)
- 6: Bucket cylinder
- 7: Arm cylinder
- 8: Boom cylinder
- 9: Turning hydraulic motor
- 10: Traveling hydraulic motor
- 11: Starter motor
- 12: Lead-acid battery (first electrical storage device)
- 13: Vehicle body controller
- 14: First electric system
- 15: Second electric system
- 16: 24V electrical equipment
- 17: Relay (disconnecting device)
- 18: 48V battery (second electrical storage device)
- 19: Third electric system
- 20: Generator
- 21: Engine fan
- 22: ECU
- 23: Pilot pump motor
- 24: DC/DC converter (voltage converter)
- 25: Pilot pump
- 26: Bucket
- 27: Arm
- 28: Boom
- 29: Turning body
- 30: Traveling body

## Claims

1. A construction machine comprising:
an engine;
a starter motor configured to start the engine with electric power supplied from a first electrical storage device;
a first electric system configured to connect the first electrical storage device and the starter motor;
a second electric system configured to connect the first electrical storage device and electrical equipment, the second electric system being connected in parallel with the first electric system;
a second electrical storage device configured to supply electric power to the second electric system;
a disconnecting device capable of disconnecting power supply from the first electrical storage device to the second electric system by disconnecting connection between the first electric system and the second electric system; and
a vehicle body controller configured to control at least the starter motor and the disconnecting device, the vehicle body controller being connected to the second electric system,
wherein the vehicle body controller disables driving of the starter motor until an estimation result of a remaining amount of the first electrical storage device is higher than or equal to a threshold set in advance, and when the estimation result is higher than or equal to the threshold, disconnects the connection between the first electric system and the second electric system by using the disconnecting device.

2. The construction machine according to claim 1, further comprising:
a third electric system having a rated voltage different from that of the first electric system and the second electric system and being connected to the second electrical storage device;
a voltage converter configured to convert voltage from the third electric system to the second electric system; and
a generator configured to supply electric power to the first electric system and the second electric system via the third electric system and the voltage converter, the generator being connected to the third electric system, wherein the generator supplies the electric power with the motive power of the engine,
wherein the second electrical storage device is connected to the third electric system and configured to supply electric power to the second electric system via the voltage converter.

3. The construction machine according to claim 2, comprising:
a hydraulic pump driven by the engine;
a plurality of hydraulic actuators driven by pressure oil supplied from the hydraulic pump; and
a flow rate control valve configured to control a flow rate of pressure oil supplied to the hydraulic actuators,
wherein:
the hydraulic pump, the hydraulic actuators, and the flow rate control valve are controlled by the vehicle body controller connected to the second electric system, and
an electric motor for driving an engine fan that cools the engine is connected to the third electric system.

4. The construction machine according to any one of claims 1 to 3, further comprising:
a voltage detection unit configured to detect voltage of the second electric system; and
a current detection unit configured to detect current supplied from the second electrical storage device to the second electric system,
wherein the vehicle body controller estimates the remaining amount of the first electrical storage device based on detections results of the voltage detection unit and the current detection unit.

5. The construction machine according to any one of claims 1 to 4, wherein the vehicle body controller disables driving of the starter motor and charges the first electrical storage device with the second electrical storage device, until the estimation result is higher than or equal to the threshold.

6. The construction machine according to any one of claims 1 to 5, wherein while driving of the starter motor is disabled, the vehicle body controller notifies that the first electrical storage device is being charged.

7. The construction machine according to any one of claims 1 to 6, wherein the vehicle body controller calculates the charging time for charging the first electrical storage device based on the estimation result, the threshold, and the amount of charging current of the first electrical storage device set in advance, and notifies the calculation result.
